# EUROPEAN PATENT APPLICATION

(11) **EP 1 197 757 A2**
(43) Date of publication of application: **17.04.2002**
(21) Application number: 01308620.2
(22) Date of filing: 09.10.2001
(51) Int. Cl.: G01R 19/14

(54) **Inverter**

(30) Priority: 10.10.2000 GB 0024847
(71) Applicant: Omron Corporation, Kyoto-shi, Kyoto-fu, 600-8530 (JP)
(72) Inventor: Hollander, Martin, c/o Omron Europe BV, 2132 JD Hoofdorp (NL)
(74) Representative: Calderbank, Thomas Roger

(57) **Abstract**

Methods and apparatus are disclosed for determining the polarity of a current of a phase of an inverter, without using a current sensor. Switches of the inverter are connected in series and are switched on and off alternately such that a "dead-time" (62, 64) is produced between each switching during which both switches are off. By detecting the phase voltage (63) at the switches, and determining if that voltage is high or low during each "dead-period" (64), a signal is produced having a first value if the phase voltage (63) is high and a second value if the phase voltage is low. By determining the times of transitions between the first and second values, the invention is able to determine the polarity of the phase current corresponding to that phase voltage. The switches of the inverter are connected in series and respective freewheeling diodes are connected in parallel with the switches.

## Description

The present invention relates to an inverter. Such inverters are used for example in the control of electric motors.

In a conventional three phase pulse width modulator inverter controlling a load such as an asynchronous motor, the inverter has three pairs of switches connected in parallel across the power supply, with the switches of each pair connected in series, and the connection points of the switches being the points from which the output currents of the respective phases are obtained and fed to the motor. The switch is normally in the form of an IGBT, with a diode (freewheeling diode) connected across the IGBTs.

In such an inverter it is desirable to determine the motor load and it is known to determine this from the power factor between the motor voltage and the current. It is usually assumed that higher harmonics of the power factor can be neglected, and thus the power factor is usually expressed as cos ϕ where ϕ is the phase angle between the voltage and the current. The most common way to determine cos ϕ is to measure the voltage and current independently, and to determine the time delay between the zero crossing of the two signals. From that time delay cos ϕ can be calculated. The technique can be applied to any of the three phase current signals. It is also possible to determine cos ϕ by measuring the current through one of the switches of each phase.

However, such measurements of cos ϕ depend on the current measurement, and the known current measurement devices are expensive.

In such an inverter, it is theoretically desirable for one switch of each pair to be turned off as the other is turned on, and vice versa. However, it is also undesirable for both switches to be on simultaneously, as this causes phase shot-through, and therefore in practice it is usual for there to be a delay or "dead time" between the turn-off of one of the pairs of switches and the turn-on of the other switch of the pair. This dead time is normally seen as a necessary evil, but the freewheeling diodes in parallel with the switches make it possible for the current to freewheel through the (partly) inductive load.

The present invention is based on the realisation that it is possible to make use of the dead time to derive the polarity of the current, which enables cos ϕ to be determined without using a current sensor. At its most general, the present invention proposes that the phase voltage is determined during the dead time, and is used to determine the polarity of the phase current. A change in polarity of the phase current then defines the time at which the zero crossing of that current takes place. The times of the zero crossings can be used to determine the phase angle, and hence cos ϕ.

The present invention may be applied to any of the phases of the inverter.

Thus, the present invention permits the polarity of phase current to be determined, and this enables a phase-related value such as cos ϕ to be determined therefrom. During the dead times, it is determined whether the phase voltage has a high or low value, and this is used to generate the signal with two values, one being when the phase voltage is a high value and one being when the phase voltage is a low value, and the times of the transitions of that signal between the first value and the second value then indicate the polarity of the phase current. This can be done by comparing the times of the transitions with the times of switching of the switches.

The present invention makes use of the fact that a current is generated through one or other of the freewheeling diodes, due to inductive effects during the dead time. Normally, the inverter will be connected to a load such as a motor, which is at least partially inductive, but even when the load driven by the inverter is not itself inductive, the present invention may still be used by providing an appropriate inductive element.

It is convenient if the determination of whether the voltage has a high or low value is at the end of the dead time, e.g. by determining it at the positive-going flank of the signal which is at a high value when either switch is on, and is at a low value when both switches are off. However, other timing arrangement may be used as long as the voltage is detected during the dead time.

An embodiment of the present invention will now be described in detail, by way of example, with reference to the accompanying drawings in which:
Fig. 1 is a schematic diagram of an inverter embodying the present invention;
Fig. 2 is a graph illustrating the dead time of a pair of transistors in Fig. 1;
Fig. 3 is a graph illustrating the relationship between the dead time signal of Fig. 2 and the phase voltage;
Fig. 4 illustrates the signals of Fig. 3, over a long time period, and also shows the zero crossings of the current; and
Fig. 5 is a block diagram illustrating the steps of processing of the processor of the inverter of Fig. 1.

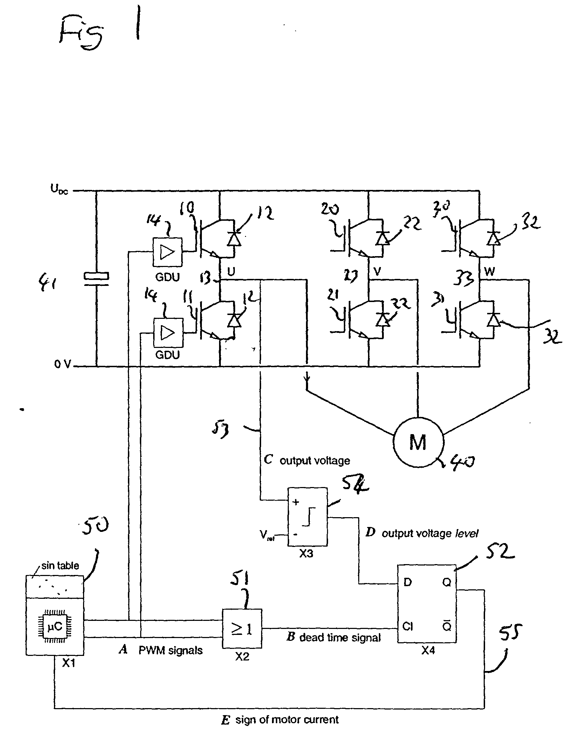

Referring first to Fig. 1, the inverter has three pairs of switches formed by transistors 10, 11; 20, 21, 30, 31 connected in parallel across a power supply U_{DC}, with the two transistors of each pair connected in series. Freewheeling diodes 12, 22, 32 are connected across each transistor. The connection points 13, 23, 33 of each pair of transistors then form the output terminals of the inverter and are then connected to a motor 40 which is to be driven by the inverter. A capacitor 41 is also connected in parallel across the power supply U_{DC}.

Each of the transistors 10, 11; 20, 21; 30, 31 has its gate terminal connected to a processor 50. In Fig. 1, only such connections to the transistors 10 and 11 are shown for the sake of clarity. The processor 50 is connected to the transistors 10, 11 via gate drive units 14 which control the switching of transistors 10, 11. The processor 50 generates pulse width modulation pulses which are amplified and level shifted by the gate drive units 14 whilst theoretically the switching on of transistor 10 should be simultaneous with the switching off of transistor 11, and vice versa, the need to avoid them both being on simultaneously results in there being a dead time when both are off. The freewheeling diodes 12 in parallel to the transistors 10, 11 make it possible for the current to freewheel through the (partly) inductive load.

If both switches 10, 11 are turned off, the voltage at connection point 13 is undefined. However, because of the fact that the load is partly inductive, there will be a current at that time. This is because the current through the load cannot change instantaneously, and therefore a current will continue to flow when both switches 10,11 are turned off. Hence the freewheeling diodes 12 are needed to permit the current to flow. The sign (or direction) of the current then determines which of the freewheeling diodes 12 conducts that current, and this determines the voltage at connection point 13. If the current is positive, then the diode across switch 11 is conducting and the voltage at connection point 13 is close to zero volts. If the current is negative, the diode 12 across switch 10 is conducting, and the voltage at connection point 13 is then close to U_{DC}.

Thus, if the voltage at connection point 13 is measured during the dead time, the polarity of the phase current may be determined. A change in polarity defines the time at which a zero crossing of the current takes place.

The detection of that zero crossing will now be described. The signals from the processor 50 to the gate drive units 14 are illustrated in Fig. 2. In Fig. 2, the signal to the transistor 10 is illustrated by line 60, and the signal to transistor 11 by line 61. As can be seen, there is a time t_dead when both transistors 10, 11 are off. The signals to the respective gate drive units 14 are also passed to an OR gate 51 which derives a dead time signal shown by line 62 in Fig. 2. That dead time signal corresponding to line 62 is passed from OR gate 51 to the clock input Cℓ of a latch 52.

At the same time, the voltage at the connection point 13 between transistors 10 and 11 is passed via connection 53 to a comparator 54 which generates a signal which is either high or low dependant on whether the voltage on connection 53 is higher or lower than a reference voltage V_{ref}. The signal generated by the comparator 54 is input to the latch 52.

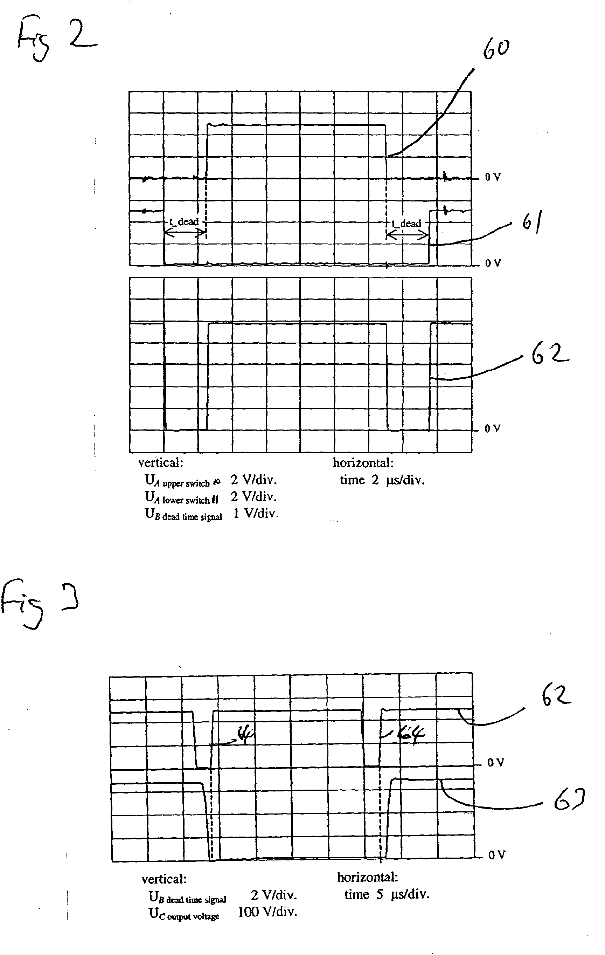

Fig. 3 then illustrates the relationship between the dead time signal 53 input to the latch 52 from gate 51 and the voltage on connection 53. Note that the time scale of Fig. 3 is slightly different from that of Fig. 2, and also that the signal 63 corresponding to line 63 in Fig. 2, being the signal on connection 53, may change its relative position. In the position shown in Fig. 3, the signal corresponding to line 63 is low at the start of both positive-going flanks 64 of the signal corresponding to line 62. As was mentioned before, if the voltage on connection 53 (corresponding to line 63 in Fig. 3) is low, this is due to the fact that the diode 12 across transistor 11 is conducting, and it is therefore known that the output current is positive. If, on the other hand, the voltage on connection 53 (corresponding to line 63 in Fig. 3) is high at the positive-going flanks 64 of the dead time signal 62, then the output current is negative. Thus, by detecting the relationship between the level of the signal on connection 53 (line 63) and the positive-going flanks 64 of the dead time signal corresponding to line 62, it is possible to determine the sign of the output current.

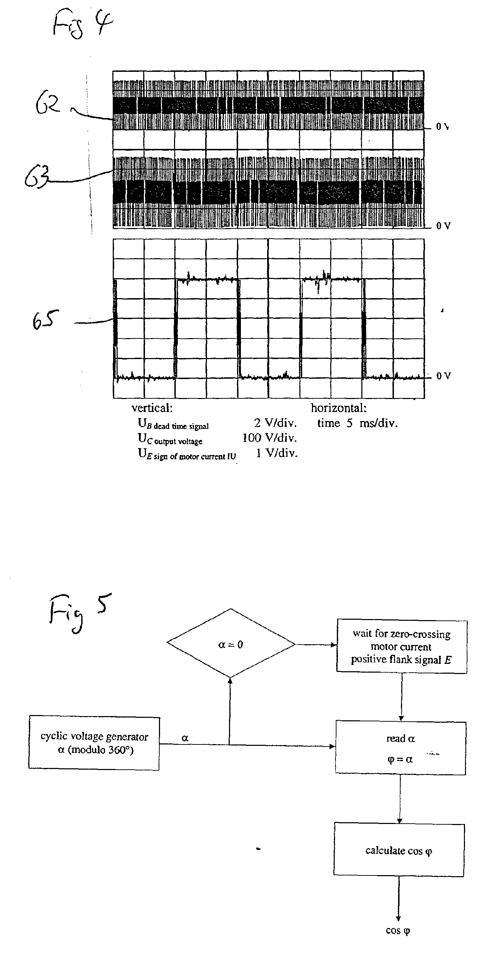

Fig. 4 then illustrates the effect of this, on a longer time scale than in Fig. 3. In Fig. 4, the upper two graphs correspond to Fig. 3 over a long time period. During that time period, there will be times when the relationship between lines 62 and 63 is identical to that in Fig. 3, and sometimes when the line 63 is non-zero at the positive-going flank 64 of line 62.

The latch 52 determines this relationship by comparing its inputs and generates an output on line 55 corresponding to line 65 in Fig. 4. This gives the sign of the motor current, and switches between two levels such as zero volts and a positive value, as the output current changes sign. In practice, due to ripple on the output current, there will be several transitions around the time at which the motor current changes sign, as illustrated by line 65 in Fig. 4 and some signal conditioning may be necessary to determine the zero crossings used. This introduces at worst only a small error to the determination of the phase angle ϕ. Line 65 in Fig. 4 also illustrates that there is noise which causes small variations in the measured values but again this does not affect the operation of the present invention as long as the level is detected correctly.

The signal output from the latch 52 on connection 55 corresponding to line 65 in Fig. 4 is then passed to the processor 50, which is also generating the pulse width modulated sinusoidal voltage. The phase shift between the zero crossing points of the voltage (determined by the signals to the gate drive units 14) and the zero crossings of the motor current derived from the line 65 on connection 55 is then the angle ϕ from which cos ϕ can be determined.

Fig. 5 illustrates the processing carried out by the processor 50. It is assumed that the processor 50 is generating a cyclic voltage with a phase angle α (modulus 360°). From the time when α=0, the processor 50 waits for a zero crossing of the motor current, as derived from line 65 on connection 55. At that zero crossing, ϕ is set for the angle α of the sinusoidal voltage at that time. Cos ϕ can then be determined. The process repeats again from α=0. Thus, the present invention permits cos ϕ to be determined without measuring the current itself, but instead relying on the detection of the zero crossings of that current within the dead time periods.

The present invention is not limited to the example described and, for example, the operations described could be applied to transistors 20, 21 or the transistors 30, 31. Moreover, although the embodiment has been described in terms of hardware, including the OR gate 51, latch 52 and comparator 54, it is possible for those components to be embodied wholly or partially as software in a suitable processing device. The signal on connection 53 may need to be converted from anolog to digital embodiment.

Moreover, it should be noted that the present invention determines cos ϕ of the output of the inverter, which is not necessarily equal to cos ϕ of the motor 40 driven by the inverter.

Nor is the invention limited to the use of an inverter driving a motor. Normally, the invention will be applied where the inverter is connected to a (partially) inductive load, although the invention could be applied to other loads if an inductive element it included which causes current to be generated through the freewheeling diodes. The inverter may have any number of phases, and any number of switches in series. The switches themselves need not be transistors as described in the embodiment above. Finally, although the embodiment describes the determination of cos ϕ, since that term is normally used to express the power factor, it will appreciated by those in the art that the power factor may be expressed in any term which relates to the relative phase position of the voltage and current, or the time delay between the voltage and current, such as sin ϕ or tan ϕ and the invention may therefore be used to determined such quantities accordingly.

## Claims

1. A method of determining the polarity of the current of a phase of an inverter having at least two switches, with the switches being connected in series and respective freewheeling diodes being connected in parallel with the switches
the method comprising:
switching the switches on and off alternately, the switching being such that there is a predetermined duration between each switching during which the switches are both off;
detecting the phase voltage at the connection of the switches;
determining if said voltage has a high or low value during each said predetermined duration and generating a signal which has a first value when said voltage has a high value during of any one of said predetermined durations and has a second value when said voltage has a low value during of any one of said predetermined durations; and
determining the times of transitions between said first and second values, thereby to determining the polarity of the phase current corresponding to said phase voltage.

2. A method according to claim 1, wherein the determining of said voltage has a high or low value is at the end of each said predetermined duration.

3. A method according to claim 1 or claim 2, wherein the times of said transitions are compared with the times of switching of said switches, so as to derive the phase relationship therebetween.

4. A apparatus for determining the polarity of the current of a phase of an inverter, the inverter having at least two switches, with the switches being connected in series and respective freewheeling diodes being connected in parallel with the switches, the apparatus comprising:
means for switching the switches on and off alternately, the switching being such that there is a predetermined duration between each switching during which the switches are both off;
means for detecting the phase voltage at the connection of the switches;
means for determining if said voltage has a high or low value during each said predetermined duration and generating a signal which has a first value when said voltage has a high value during of any one of said predetermined durations and has a second value when said voltage has a low value during of any one of said predetermined durations; and
means for determining the times of transitions between said first and second values, thereby to determining the polarity of the phase current corresponding to said phase voltage.

5. An apparatus according to claim 4, further comprising means for comparing the times of said transistors with the times of switching of said switches, so as to derive the phase relationship therebetween.
